# FASCICULE DE BREVET EUROPEEN

(11) **EP 2 764 611 B1**
(45) Date de publication et mention de la délivrance du brevet: **09.03.2022**
(21) Numéro de dépôt: 12780085.2
(22) Date de dépôt: 04.10.2012
(51) Int. Cl.: H02M 1/08, H02M 7/537, H03K 17/687, H03K 17/06, H02M 3/07

(54) **CIRCUIT DE COMMANDE D'UN CIRCUIT ELEVATEUR DE TENSION**
STEUERSCHALTUNG FÜR EINE HOCHSETZSTELLER SCHALTUNG, STEUERGERÄT UND ENTSPRECHENDES REGELSYSTEM
CONTROL CIRCUIT FOR A VOLTAGE BOOST CONVERTER CIRCUIT, CONTROL DEVICE AND CORRESPONDING REGULATION SYSTEM

(30) Priorité: 05.10.2011 FR 1103028
(43) Date de publication de la demande: 13.08.2014
(73) Titulaire: VALEO SYSTEMES THERMIQUES, 78321 Le Mesnil St Denis Cedex (FR)
(72) Inventeur: CHAUVIN, Karen, F-78230 Le Pecq (FR)
(74) Mandataire: Valeo Systèmes Thermiques
(86) Numéro de dépôt international: PCT/EP2012/004142
(87) Numéro de publication internationale: WO 2013/050141

(56) Documents cités:
- EP-A1- 1 511 172
- WO-A1-2005/043549
- WO-A2-2006/062936
- US-A- 4 540 893
- US-B1- 6 201 718
- Jim Lesurf: "Differential Amplifiers and Current Sources", , 18 May 2000 (2000-05-18), pages 1-5, XP055308793, St Andrews, Fife KY16 9SS, Scotland Retrieved from the Internet: URL:https://www.st-andrews.ac.uk/~www_pa/S cots_Guide/audio/part1/page3.html [retrieved on 2016-10-07]

## Description

La présente invention concerne un circuit de commande d'un circuit élévateur de tension. Elle concerne également un circuit élévateur de tension, un dispositif de commande d'un transistor MOSFET à canal N et un système de régulation de la vitesse de rotation d'un groupe moto-ventilateur équipant une installation de ventilation, de chauffage et/ou de climatisation pour véhicule automobile.

Plus particulièrement, la présente invention concerne le domaine technique des véhicules automobiles équipés du système d'arrêt et de redémarrage automatique du moteur à combustion interne connu sous l'appellation « Stop & Start ».

La fonction « Stop & Start » arrête le moteur à combustion interne lorsque le véhicule est à l'arrêt, par exemple en raison d'un passage à un feu rouge. Quand la circulation devient à nouveau possible, la fonction « Stop & Start » met en œuvre un démarrage rapide du moteur à combustion interne. Une telle mise en service provoque une chute de tension sur le réseau de bord du véhicule telle que la tension de ce réseau peut passer en dessous d'un seuil déterminé, en dessous duquel certains équipements se mettent à l'arrêt. Parmi ces équipements, on trouve le groupe moto-ventilateur, ou GMV, qui assure une circulation d'un flux d'air vers l'habitacle en vue de le conditionner thermiquement. Ainsi, cette chute de tension au démarrage du moteur à combustion interne arrête le GMV et dégrade alors le conditionnement thermique de l'habitacle.

Pour la régulation de la vitesse de rotation du GMV, un transistor MOSFET à canal N, raccordé entre la tension d'alimentation et le GMV et commandé par sa tension de grille, est utilisé.

Lors de l'arrêt et redémarrage automatique du véhicule, par exemple en raison d'un passage à un feu rouge, la tension de grille du transistor MOSFET chute. Cette chute peut descendre à un niveau tel que le transistor MOSFET fonctionne en mode linéaire et ne peut donc plus assurer la régulation du GMV.

Les systèmes de régulation de l'état de la technique, comme par exemple le document EP 1 511 172, ne prévoient pas de solution pour remédier à ce risque.

La présente invention vise à améliorer la situation en proposant un moyen permettant de limiter au maximum une chute de la tension de grille du transistor MOSFET lors du redémarrage du véhicule.

A cet effet, l'invention concerne un circuit de commande d'un circuit élévateur de tension selon la revendication 1.

La première résistance et la diode raccordant respectivement l'émetteur et la base du deuxième transistor NPN à la masse permettent de contrôler précisément la différence de potentiel aux bornes de ladite première résistance et de limiter le courant circulant dans les deux transistors lors d'un court-circuit. De manière remarquable, l'utilisation de la diode garantit une homogénéité du circuit vis-à-vis des variations de température, la tension de la diode variant de la même manière que la tension entre la base et l'émetteur du deuxième transistor NPN.

Cet étage de sortie comprenant deux diodes et deux condensateurs constitue ainsi une pompe de charge fonctionnant en doubleur de tension.

Selon une réalisation préférée, la base du deuxième transistor est raccordée à la masse à travers trois diodes disposées en série.

Ce nombre de diodes permet d'assurer la tension nécessaire pour commander le deuxième transistor NPN dans les cas d'utilisation les plus sévères. Ces cas d'utilisation les plus sévères ont lieu par exemple pour des températures variant de - 40°C à 150°C et concernent également les pires cas technologiques des composants.

Avantageusement, la valeur de la première résistance est inférieure à dix ohms.

Cette valeur assure un compromis entre la nécessité de garantir le respect des conditions limites d'utilisation des transistors pendant le temps de court-circuit et la nécessité de limiter la chute de tension aux bornes de cette première résistance. Avantageusement, la base du deuxième transistor est raccordée à une tension de référence à travers une deuxième résistance.

Cela permet de maîtriser la tension de la base du deuxième transistor NPN.

Avantageusement, l'étage d'entrée comprend un pont diviseur de tension raccordé à la base du premier transistor.

De préférence, le pont diviseur de tension comprend deux résistances.

L'invention concerne également un dispositif de commande d'un transistor MOSFET à canal N comprenant un circuit élévateur de tension selon l'invention.

L'invention concerne aussi un système de régulation de la vitesse de rotation d'un groupe moto-ventilateur équipant une installation de ventilation, de chauffage et/ou de climatisation pour véhicule automobile, comprenant un transistor MOSFET à canal N et un dispositif de commande dudit transistor MOSFET selon l'invention.

Le transistor MOSFET est raccordé, de préférence, entre une tension d'alimentation et le groupe moto-ventilateur.

Le terme « raccordé » signifie, dans toute la description de la présente invention, connecté directement ou par l'intermédiaire d'une résistance de faible impédance.

Des exemples de réalisation de l'invention vont maintenant être décrits de façon plus précise, mais non limitative, en regard des dessins annexés sur lesquels :
- la figure 1 est un schéma illustrant la structure d'un circuit élévateur de tension comprenant un circuit de commande selon un mode de réalisation de l'invention; et
- la figure 2 est un schéma illustrant la structure d'un système de régulation selon un mode de réalisation de l'invention.

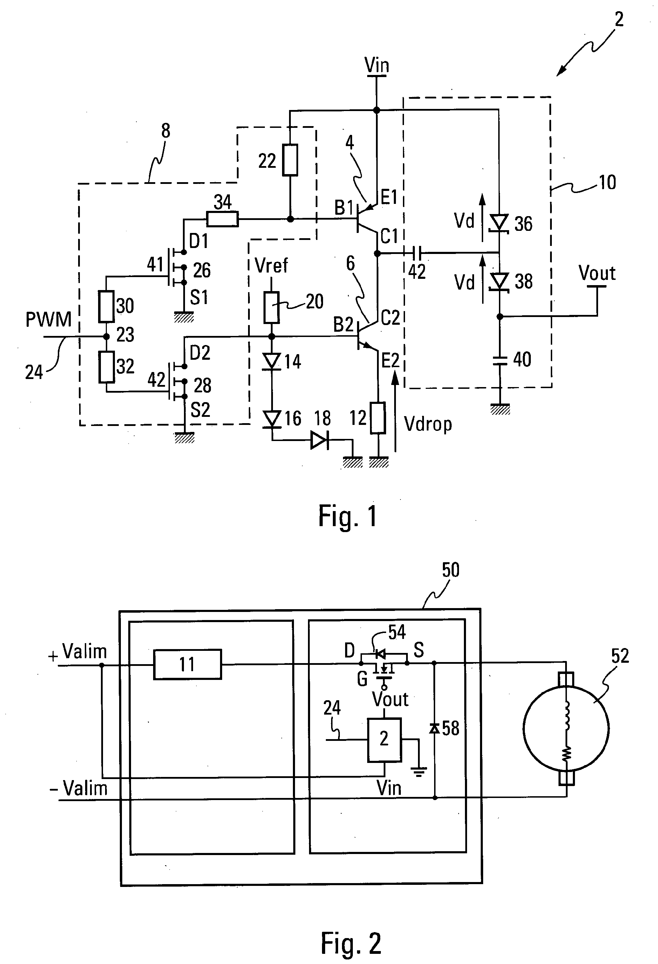

La figure 1 représente un circuit élévateur de tension 2 selon un mode de réalisation préféré de l'invention.

Le circuit 2 comprend un circuit de commande 1 comprenant principalement deux transistors bipolaires 4, 6, un étage d'entrée 8 pour commander l'ouverture et la fermeture des transistors 4, 6 et un étage de sortie 10 aux bornes duquel est récupérée une tension de sortie Vout.

Le premier transistor bipolaire 4 est un transistor PNP dont l'émetteur E1 est raccordé à la tension d'entrée Vin, la base B1 est raccordée à l'étage d'entrée 8 et le collecteur C1 est raccordé à l'étage de sortie 10.

Le deuxième transistor bipolaire 6 est un transistor NPN dont le collecteur C2 est raccordé au collecteur C1 du premier transistor 4, la base B2 est raccordée à l'étage d'entrée 8 et l'émetteur E2 est raccordé à la masse à travers une première résistance 12. La valeur de cette première résistance 12 est inférieure à 10 ohms, par exemple égale à 5 ohms.

La base B2 du deuxième transistor NPN 6 est en outre raccordée à la masse, à travers au moins une et avantageusement selon l'exemple de la figure 1, trois diodes 14, 16, 18 disposées successivement en série et orientées selon un même sens, l'anode de la diode 14 étant raccordée à la base B2 et la cathode de la diode 18 étant raccordée à la masse.

La base B2 du deuxième transistor NPN 6 est également raccordée à une tension de référence Vref, égale à 5V par exemple, à travers une deuxième résistance 20.

Grâce à la tension de référence Vref, aux diodes 14, 16, 18 et à la résistance 12, la tension de la base B2 est complètement maîtrisée.

L'étage d'entrée 8 est apte à recevoir, sur une borne d'entrée 23, un signal de commande de modulation d'impulsion en largeur 24, dite commande PWM (« Pulse Width Modulation »), depuis un microcontrôleur non représenté.

Cet étage d'entrée 8 comprend deux transistors MOSFET 26, 28 dont les grilles G1, G2 sont raccordées à la borne d'entrée 23 du signal PWM par l'intermédiaire de deux résistances 30, 32 respectivement.

Le drain D1 du premier transistor MOSFET 26 est raccordé à la base B1 du premier transistor PNP 4 et à une tension d'entrée Vin à travers un pont diviseur de tension comprenant une résistance 22 et une résistance 34 et sa source S1 est raccordée à la masse.

Le drain D2 du deuxième transistor MOSFET 28 est raccordé à la base B2 du deuxième transistor NPN 6 et sa source S2 est raccordée à la masse.

Cette configuration de l'étage d'entrée 8 permet d'assurer que lorsque le signal de commande PWM est au niveau logique 1, correspondant typiquement à une tension de 5V en sortie du microcontrôleur, le premier transistor PNP 4 est fermé et le deuxième transistor NPN 6 est ouvert. A l'inverse, lorsque le signal de commande PWM est au niveau logique 0, correspondant typiquement à une tension de 0V en sortie du microcontrôleur, le premier transistor PNP 4 est ouvert et le deuxième transistor NPN 6 est fermé.

De manière remarquable ici, les résistances 20, 22, 34 sont choisies de manière à limiter le temps pendant lequel les transistors bipolaires 4, 6 sont tous les deux fermés, c'est-à-dire le temps d'ouverture du premier transistor PNP 4 et de fermeture du deuxième transistor NPN 6, et vice versa. Ce temps, pendant lequel il y a un court-circuit entre la tension d'entrée Vin et la masse, doit en effet être réduit pour éviter de trop solliciter les composants du circuit 2, notamment les transistors bipolaires 4, 6 et la première résistance 12.

La valeur de la première résistance 12, inférieure à 10 ohms, assure un compromis entre la nécessité de garantir le respect des conditions limites d'utilisation des transistors 4, 6 pendant le temps de court-circuit et la nécessité de limiter la chute de tension aux bornes de cette première résistance 12.

L'étage de sortie 10 comprend deux diodes 36, 38, notamment de type Schottky, et un premier condensateur 40 raccordés en série successivement entre la tension d'entrée Vin et la masse ainsi qu'un deuxième condensateur 42 raccordé entre le collecteur C1 du premier transistor PNP 4 et les deux diodes Schottky 36, 38. L'anode de la première diode Schottky 36 est raccordée à la tension d'entrée Vin et sa cathode est raccordée à l'anode de la deuxième diode Schottky 38, la cathode de cette dernière étant raccordée au premier condensateur 40.

L'étage de sortie 10 constitue ainsi une pompe de charge permettant de doubler la tension d'entrée Vin pour obtenir une tension de sortie Vout quasiment égale à 2*Vin.

Typiquement, la tension Vin est la tension de la batterie d'un véhicule automobile, c'est-à-dire une tension comprise entre 6V et 18V.

La tension de sortie Vout est la tension aux bornes du premier condensateur 40.

Après le temps de court-circuit évoqué ci-dessus, le courant traversant la première résistance 12 est très faible, de l'ordre de la dizaine de milliampères, de sorte que la tension aux bornes de la première résistance 12 notée Vdrop est de l'ordre de la centaine de millivolts. Le courant de charge du condensateur 42 étant très faible, aucun courant ne traverse les trois diodes 14, 16, 18.

En sortie du circuit 2, la tension de sortie Vout est égale à 2*Vin-Vdrop-2*Vd, où Vd est la tension aux bornes de chacune des diodes Schottky 36, 38. La tension Vd étant de l'ordre de 300mV, la tension Vdrop est négligeable par rapport à 2*Vd.

Grâce au circuit de l'invention, comprenant des composants de faible coût, il est possible, par exemple, d'obtenir une tension de sortie Vout = 2*Vin - 0.7V.

De manière remarquable, grâce à la connexion du premier transistor PNP 4 à la tension d'entrée et du deuxième transistor NPN 6 à la masse, les tensions entre la base et l'émetteur des transistors bipolaires 4, 6 ne génèrent pas de perte au niveau de la tension de sortie Vout.

La figure 2 illustre un système 50 de régulation de la vitesse de rotation d'un groupe moto-ventilateur GMV 52 équipant une installation de ventilation, de chauffage et/ou de climatisation pour véhicule automobile.

Ce système de régulation 50 comprend un transistor MOSFET à canal N 54 dont le drain D est raccordé, à travers un filtre 56, à une tension d'alimentation positive Valim et dont la source S est raccordée à la borne positive du GMV 52. Aux bornes du moteur est connectée une diode 58. Ici, la tension Valim est égale à la tension Vin de la batterie du véhicule.

Le transistor MOSFET 54 est commandé, au niveau de sa grille G, par la tension de sortie Vout du circuit élévateur 2.

Comme le circuit élévateur 2 fonctionne en doubleur quasiment parfait, avec une tension de batterie Vin faible, par exemple de l'ordre de 7V, la tension Vout de commande du transistor MOSFET 54 est suffisante pour garantir que le transistor MOSFET 54 ne passe pas en mode linéaire et que le GMV 52 ne s'arrête pas de fonctionner.

Bien entendu, d'autres modes de réalisation sont envisageables.

Grâce à la connexion du premier transistor PNP 4 à la tension d'entrée et du deuxième transistor NPN 6 à la masse, les tensions entre la base et l'émetteur des transistors bipolaires 4, 6 ne génèrent pas de perte au niveau de la tension de sortie Vout, comme déjà expliqué.

Grâce à la résistance 12 et à la ou aux diode(s) 14, 16 et 18, l'intensité traversant les transistors 4 et 6 est limitée pendant la phase de changement d'état logique du signal de commande PWM 24 tout en assurant, en fonctionnement pendant un état logique du signal de commande PWM 24 donné, que la tension aux bornes de la résistance 12 est faible et qu'aucun courant ne traverse les diodes 14, 16 et 18, de sorte que le circuit de commande 1 répercute peu de perte sur la tension de sortie Vout, comme expliqué ci-dessus.

Ainsi, grâce au circuit de commande selon l'invention, il est possible de commander un transistor MOSFET avec une tension d'alimentation faible et d'assurer que le GMV 52 ne s'arrête pas de fonctionner, du fait que la tension de sortie Vout est suffisante pour garantir que le transistor MOSFET 54 ne passe pas en mode linéaire, comme expliqué ci-dessus.

## Revendications

1. Circuit élévateur de tension (2) comprenant un circuit de commande, un étage d'entrée (8) et un étage de sortie (10),
le circuit de commande comprenant :
- un premier transistor PNP (4) dont l'émetteur (E1) est raccordé à une tension d'entrée (Vin);
- un deuxième transistor NPN (6) dont le collecteur (C2) est raccordé au collecteur (C1) du premier transistor (4), l'émetteur (E2) du deuxième transistor (6) étant raccordé à une masse,
dans lequel l'émetteur (E2) dudit deuxième transistor (6) est raccordé à la masse à travers une première résistance (12) et sa base (B2) est raccordée à la masse à travers au moins une diode (14, 16, 18), dans lequel la base (B2) du deuxième transistor (6) est raccordée à une tension de référence (Vref) à travers une deuxième résistance (20),
dans lequel l'étage de sortie (10) est raccordé aux collecteurs (C1, C2) des premier et deuxième transistors (4, 6), aux bornes duquel est récupérée une tension de sortie (Vout) supérieure à la tension d'entrée (Vin),
dans lequel l'étage d'entrée (8) est raccordé aux bases (B1, B2) des premier et deuxième transistors (4, 6), pour commander l'ouverture et la fermeture desdits transistors (4, 6),
dans lequel l'étage d'entrée (8) est apte à recevoir une commande de modulation d'impulsion en largeur (24) sur une borne d'entrée (23) dudit étage d'entrée (8), dans lequel l'étage d'entrée (8) comprend deux transistors MOSFET (26, 28) dont les grilles (G1, G2) sont raccordées à la borne d'entrée (23),
dans lequel le drain (D1) du premier transistor MOSFET (26) est raccordé à la base (B1) du premier transistor (4) et à une tension d'entrée (Vin) à travers un pont diviseur de tension comprenant une résistance (22) et une résistance (34), et sa source (S1) est raccordée à la masse,
dans lequel le drain (D2) du deuxième transistor MOSFET (28) est raccordé à la base (B2) du deuxième transistor (6) et sa source (S2) est raccordée à la masse, et dans lequel l'étage de sortie (10) comprend :
- deux diodes (36, 38) et un premier condensateur (40) raccordés en série successivement entre la tension d'entrée (Vin) et la masse, les diodes (36, 38) étant des diodes Schottky ; et
- un deuxième condensateur (42) raccordé entre le collecteur (C1) du premier transistor (4) et les deux diodes (36, 38), l'anode de la première diode Schottky (36) étant raccordée à la tension d'entrée (Vin) et sa cathode étant raccordée à l'anode de la deuxième diode Schottky (38), la cathode de cette dernière étant raccordée au premier condensateur (40),
la tension de sortie (Vout) étant égale à la tension aux bornes du premier condensateur (40).

2. Circuit élévateur de tension (2) selon la revendication 1, dans lequel la base (B2) du deuxième transistor (6) du circuit de commande est raccordée à la masse à travers trois diodes (14, 16, 18) disposées en série.

3. Circuit élévateur de tension (2) selon la revendication 1 ou 2, dans lequel la valeur de la première résistance (12) du circuit de commande est inférieure à dix ohms.

4. Circuit élévateur (2) selon l'une quelconque des revendications précédentes, dans lequel l'étage d'entrée (8) comprend un pont diviseur de tension (22, 34) raccordé à la base (B1) du premier transistor (4).

5. Dispositif de commande d'un transistor MOSFET à canal N (54) comprenant un circuit élévateur de tension (2) selon l'une quelconque des revendications précédentes.

6. Système de régulation (50) de la vitesse de rotation d'un groupe moto-ventilateur (52) équipant une installation de ventilation, de chauffage et/ou de climatisation pour véhicule automobile, comprenant un transistor MOSFET à canal N (54) et un dispositif de commande dudit transistor MOSFET (54) selon la revendication 5.

## Patentansprüche

1. Hochsetzstellerschaltung (2), die eine Steuerschaltung, eine Eingangsstufe (8) und eine Ausgangsstufe (10) umfasst, wobei die Steuerschaltung umfasst:
- einen ersten PNP-Transistor (4), dessen Emitter (E1) an eine Eingangsspannung (Vin) angeschlossen ist;
- einen zweiten NPN-Transistor(6), dessen Kollektor (C2) an den Kollektor (C1) des ersten Transistors (4) angeschlossen ist, wobei der Emitter (E2) des zweiten Transistors (6) an eine Masse angeschlossen ist,
wobei der Emitter (E2) des zweiten Transistors (6) an die Masse über einen ersten Widerstand (12) angeschlossen ist und seine Basis (B2) an die Masse über mindestens eine Diode (14, 16, 18) angeschlossen ist, wobei die Basis (B2) des zweiten Transistors (6) an eine Referenzspannung (Vref) über einen zweiten Widerstand (20) angeschlossen ist,
wobei die Ausgangsstufe (10) an die Kollektoren (C1, C2) des ersten und des zweiten Transistors (4, 6), an deren Klemmen eine Ausgangsspannung (Vout) abgegriffen wird, die größer als die Eingangsspannung (Vin) ist,
wobei die Eingangsstufe (8) an die Basen (B1, B2) des ersten und des zweiten Transistors (4, 6) angeschlossen ist, um das Öffnen und das Schließen der Transistoren (4, 6) zu steuern,
wobei die Eingangsstufe (8) geeignet ist, einen Pulsweitenmodulationsbefehl (24) über eine Eingangsklemme (23) der Eingangsstufe (8) zu empfangen, wobei die Eingangsstufe (8) zwei MOSFET-Transistoren (26, 28) umfasst, deren Gates (G1, G2) an die Eingangsklemme (23) angeschlossen sind,
und wobei der Drain (D1) des ersten MOSFET-Transistors (26) an die Basis (B1) des ersten Transistors (4) und an eine Eingangsspannung (Vin) über eine Spannungsteilerbrücke angeschlossen ist, die einen Widerstand (22) und einen Widerstand (34) umfasst, und seine Source (S1) an die Masse angeschlossen ist,
wobei der Drain (D2) des zweiten MOSFET-Transistors (28) an die Basis (B2) des zweiten Transistors (6) angeschlossen ist und seine Source (S2) an die Masse angeschlossen ist,
und wobei die Ausgangsstufe (10) umfasst:
- zwei Dioden (36, 38) und einen ersten Kondensator (40), die hintereinander in Reihe zwischen der Eingangsspannung (Vin) und der Masse angeschlossen sind, wobei die Dioden (36, 38) Schottky-Dioden sind; und
- ein zweiter Kondensator (42) zwischen dem Kollektor (C1) des ersten Transistors (4) und den beiden Dioden (36, 38) angeschlossen ist, wobei die Anode der ersten Schottky-Diode (36) an die Eingangsspannung (Vin) angeschlossen ist und ihre Kathode an die Anode der zweiten Schottky-Diode (38) angeschlossen ist, wobei deren Kathode an den ersten Kondensator (40) angeschlossen ist,
wobei die Ausgangsspannung (Vout) gleich der Spannung an den Klemmen des ersten Kondensators (40) ist.

2. Hochsetzstellerschaltung (2) nach Anspruch 1, bei der die Basis (B2) des zweiten Transistors (6) der Steuerschaltung an die Masse über drei in Reihe angeordnete Dioden (14, 16, 18) angeschlossen ist.

3. Hochsetzstellerschaltung (2) nach Anspruch 1 oder 2, bei welcher der Wert des ersten Widerstands (12) der Steuerschaltung kleiner als zehn Ohm ist.

4. Hochsetzstellerschaltung (2) nach einem der vorhergehenden Ansprüche, bei der die Eingangsstufe (8) eine Spannungsteilerbrücke (22, 34) umfasst, die an die Basis (B1) des ersten Transistors (4) angeschlossen ist.

5. Vorrichtung zur Steuerung eines N-Kanal-MOSFET-Transistors (54), umfassend eine Hochsetzstellerschaltung (2) nach einem der vorhergehenden Ansprüche.

6. Drehzahlregelungssystem (50) für eine Gebläseeinheit (52), mit der eine Lüftungs-, Heizungs- und/oder Klimaanlage für ein Kraftfahrzeug ausgestattet ist, umfassend einen N-Kanal-MOSFET-Transistor (54) und eine Vorrichtung zur Steuerung des MOSFET-Transistors (54) nach Anspruch 5.

## Claims

1. Voltage boost converter circuit (2) comprising a control circuit, an input stage (8) and an output stage (10),
the control circuit comprising:
- a first, PNP transistor (4), the emitter (E1) of which is connected to an input voltage (Vin);
- a second, NPN transistor (6), the collector (C2) of which is connected to the collector (C1) of the first transistor (4), the emitter (E2) of the second transistor (6) being connected to ground,
wherein the emitter (E2) of said second transistor (6) is connected to ground through a first resistor (12) and its base (B2) is connected to ground through at least one diode (14, 16, 18), wherein the base (B2) of the second transistor (6) is connected to a reference voltage (Vref) through a second resistor (20),
wherein the output stage (10) is connected to the collectors (C1, C2) of the first and second transistors (4, 6), at the terminals of which an output voltage (Vout) higher than the input voltage (Vin) is recovered,
wherein the input stage (8) is connected to the bases (B1, B2) of the first and second transistors (4, 6), in order to control the opening and closing of said transistors (4, 6),
wherein the input stage (8) is capable of receiving a pulse-width-modulation command (24) over an input terminal (23) of said input stage (8),
wherein the input stage (8) comprises two MOSFETs (26, 28), the gates (G1, G2) of which are connected to the input terminal (23),
wherein the drain (D1) of the first MOSFET (26) is connected to the base (B1) of the first transistor (4) and to an input voltage (Vin) through a voltage divider bridge comprising a resistor (22) and a resistor (34), and its source (S1) is connected to ground,
wherein the drain (D2) of the second MOSFET (28) is connected to the base (B2) of the second transistor (6) and its source (S2) is connected to ground, and wherein the output stage (10) comprises:
- two diodes (36, 38) and a first capacitor (40) that are connected in series in succession between the input voltage (Vin) and ground, the diodes (36, 38) being Schottky diodes; and
- a second capacitor (42) connected between the collector (C1) of the first transistor (4) and the two diodes (36, 38), the anode of the first Schottky diode (36) being connected to the input voltage (Vin) and its cathode being connected to the anode of the second Schottky diode (38), the cathode of the latter being connected to the first capacitor (40),
the output voltage (Vout) being equal to the voltage across the terminals of the first capacitor (40).

2. Voltage boost converter circuit (2) according to Claim 1, wherein the base (B2) of the second transistor (6) of the control circuit is connected to ground through three diodes (14, 16, 18) arranged in series.

3. Voltage boost converter circuit (2) according to Claim 1 or 2, wherein the value of the first resistor (12) of the control circuit is lower than ten ohms.

4. Boost converter circuit (2) according to any one of the preceding claims, wherein the input stage (8) comprises a voltage divider bridge (22, 24) connected to the base (B1) of the first transistor (4) .

5. Device for controlling an N-channel MOSFET (54) comprising a voltage boost converter circuit (2) according to any one of the preceding claims.

6. System (50) for regulating the speed of rotation of a motor-fan unit (52) for a ventilation, heating and/or air-conditioning setup for a motor vehicle, comprising an N-channel MOSFET (54) and a device for controlling said N-channel MOSFET (54) according to Claim 5.
